## Europäisches Patentamt

## European Patent Office

## Office européen des brevets

(11) Veröffentlichungsnummer: **0 078 364**
**B1**

## EUROPÄISCHE PATENTSCHRIFT

(45) Veröffentlichungstag der Patentschrift:
08.06.88

(51) Int. Cl.⁴: **H 01 L 31/02**

(21) Anmeldenummer: **82106675.0**

(22) Anmeldetag: **23.07.82**

(54) Opto-elektrische Koppelanordnung.

(30) Priorität: **29.10.81 DE 3142918**

(43) Veröffentlichungstag der Anmeldung:
**11.05.83 Patentblatt 83/19**

(45) Bekanntmachung des Hinweises auf die Patenterteilung:
**08.06.88 Patentblatt 88/23**

(84) Benannte Vertragsstaaten:
**AT CH DE FR GB IT LI NL SE**

(56) Entgegenhaltungen:
**US-A-4 210 923**
**US-A-4 225 213**

**IBM TECHNICAL DISCLOSURE BULLETIN, Band 50, Nr. 11, April 1980, New York, US. F.E. NOEL et al.: "High Density Fiber-Optic Transducer Modules", Seiten 4857-4858**
**IBM TECHNICAL DISCLOSURE BULLETIN, vol. 22, No. 7, December 1979, New York (US). L. D. COMERFORD: "Etched silicon structure for aligning a photo-diode and optical fiber", Seiten 2935-2936**

(73) Patentinhaber: **Licentia Patent- Verwaltungs- GmbH, Theodor- Stern- Kai 1, D-6000 Frankfurt/Main 70 (DE)**

(72) Erfinder: **Becker, Reinhard, Dr. Dr.- Ing, Entw.- Ing., verstorben (DE)**
Erfinder: **Schurr, Anton, Hudlerstrasse 27, D-7913 Senden- Wullenstetten (DE)**
Erfinder: **Müssigmann, Artur, Georg- Zoller- Strasse 22, D-7930 Ehingen (DE)**

(74) Vertreter: **Schulze, Harald Rudolf, Dipl.- Ing., Licentia Patent- Verwaltungs- GmbH Theodor- Stern- Kai 1, D-6000 Frankfurt/Main 70 (DE)**

## Beschreibung

Die Erfindung betrifft eine opto-elektrische Koppelanordnung nach dem Oberbegriff des Patentanspruchs 1.

Eine derartige Koppelanordnung ist bekannt aus der Schrift "IBM Technical Disclosure Bulletin, Band 22, No. 11, April 1980, Seiten 4857 bis 4858". Die dort beschriebene Koppelanordnung enthält einen Trägerkörper, in dem mehrere parallel nebeneinander liegende grabenförmige Vertiefungen (Schlitze) angebracht sind. In jede dieser Vertiefungen ist ein Lichtwellenleiter einleg- und fixierbar, z. B. durch Kleben. Gegenüber von den Endflächen (Lichtaustrittsflächen) der Lichtwellenleiter befindet sich eine Halterung, auf der mehrere Halbleiter-Photodetektoren derart befestigt sind, daß jedem Photodetektor ein Lichtwellenleiter zugeordnet ist. Die Photodetektoren sind über elektrische Leiterbahnen, die zu einer gedruckten Schaltung gehören, mit mindestens einem integrierten Schaltkreis verbunden, in welchem das von den Photodetekoren erzeugte elektrische Signal weiterverarbeitet wird.

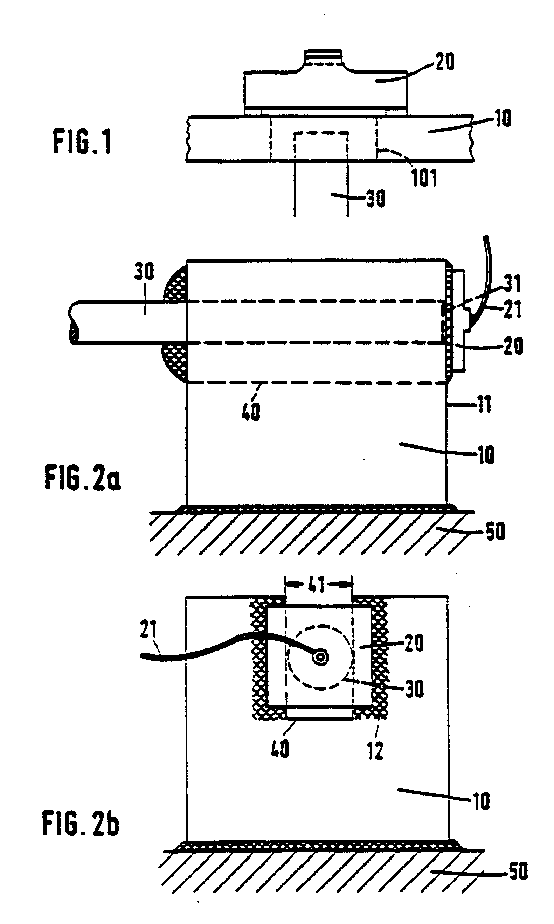

Weiterhin wurde eine Koppelanordnung gemäß Fig. 1 vorgeschlagen. Dabei ist in einem Trägerelement 10 ein Durchgangsloch 101 vorhanden, in dem ein Lichtwellenleiter 39 angeordnet ist. An dem Trägerelement 10 ist außerdem ein Photodetektor 20 befestigt, der das aus dem Lichtwellenleiter 30 austretende Licht in einen elektrischen Strom und/oder eine elektrische Spannung umwandelt, die zur Nachrichtengewinnung ausgewertet wird.

Eine derartige Koppelanordnung hat insbesondere den Nachteil, daß ein Durchgangsloch 101 mit einem, im Vergleich zur Dicke des Trägerelementes (einige Millimeter), kleinen Durchmesser (ca. 0,1 mm bis 0,2 mm) erforderlich ist sofern optische Glasfasern als Lichtwellenleiter 30 verwendet werden. Derartige Durchgangslöcher sind schwierig herstellbar und daher kostenintensiv. Außerdem ist es technisch aufwendig, den Photodetektor 20 optimal zu justieren, da die im allgemeinen mit Toleranzen behaftete Lage des Lichtwellenleiters 30 erst bestimmt werden muß.

Aufgabe der Erfindung ist es daher, eine opto-elektrische Koppelanordnung anzugeben, die kostengünstig herstellbar ist und die insbesondere für hohe Nachrichtenübertragungsraten geeignet ist.

Diese Aufgabe wird erfindungsgemäß gelöst durch die im kennzeichnenden Teil des Patentanspruchs 1 angegebenen Merkmale.

Weiterbildungen und Ausgestaltungen der Erfindung sind den Unteransprüchen entnehmbar.

Ein Vorteil der Erfindung besteht darin, daß die Koppelanordnung mechanisch unempfindlich und elektrisch kapazitätsarm ausführbar ist.

Die Erfindung wird im folgenden anhand von Ausführungsbeispielen unter Bezugnahme auf schematische Zeichnungen näher erläutert. Es zeigen:

FIG. 2a und 2b Seitenansichten eines ersten Ausführungsbeispieles

FIG. 3 ein weiteres Ausführungsbeispiel

Die Erfindung beruht darauf, daß es technisch wesentlich einfacher ist, und daher kostengünstiger, schmale grabenförmige Vertiefungen und/oder Schlitze herzustellen als tiefe Durchgangslöcher mit einem kleinen Durchmesser zu bohren. Beispielsweise kann eine Vertiefung (Schlitz) mit einer Länge von 10 mm, einer Breite von 0,25 mm und einer Tiefe von 5 mm auf technisch einfache Weise in ein Metallstück gesägt oder gefräst werden. Dagegen ist es schwierig, in dasselbe Metallstück z. B. ein Loch mit einer Tiefe von 5 mm und einem Durchmesser von 0,25 mm zu bohren.

In dem Ausführungsbeispiel gemäß den FIG. 2a und 2b ist in eine erste Seitenfläche eines Trägerelementes 10, z. B. ein Metallwürfel mit einer Kantenlänge von 1,2 mm, eine Vertiefung 40 eingefräst, z. B. ein durchgehender Schlitz mit einer Breite 41 von 0,25 mm und einer Tiefe von 0,6 mm. Die Vertiefung 40 ist im wesentlichen parallel zu einer Kante des Trägerelementes 10 und im wesentlichen in der Mitte der ersten Seitenfläche angeordnet. Die Vertiefung 40 durchdringt eine zweite Seitenfläche 11, so daß dort die Querschnittsfläche der Vertiefung 40 sichtbar wird. Diese Querschnittsfläche dient nun vorteilhafterweise als Justierungshilfe für die Befestigung eines Photodetektors 20, z. B. eines Halbleiterphotodioden-Chips mit einer Kantenlänge von 0,5 mm, der derart an der zweiten Seitenfläche 11 angebracht ist, z. B. elektrisch leitend geklebt oder gelötet 12, daß der lichtempfindliche Bereich des Photodetektors 20 im wesentlichen in der Mitte der Querschnittsfläche liegt und der Vertiefung 40 zugewandt ist. In die Vertiefung 40 ist nun ein Lichtwellenleiter 30, z. B. eine optische Glasfaser, derart einlegbar und fixierbar (Klebung), daß das von deren Endfläche 31 ausgesandte Licht im wesentlichen vollständig auf den lichtempfindlichen Bereich des Photodetektor 20 fällt. Die beschriebene Anordnung kann nun in einfacher Weise z. B.auf einer sogenannten Leiterplatte 50 elektrisch leitend befestigt werden (geklebt, gelötet), so daß ein elektrischer Anschluß des Photodetektors 20 durch den Trägerkörper 10 gebildet wird, während der andere elektrische Anschluß z. B. mit Hilfe eines dünnen Golddrahtes 21 (Durchmesser 12 µm) hergestellt wird, z. B. gebondet. Das beschriebene Ausführungsbeispiel hat eine geringe elektrische Kapazität, so daß ein derartiges optischer Empfänger eine hohe Nachrichtenübertragungsrate ermöglicht.

Die beispielhaft angegebenen geometrischen Abmessungen der Vertiefung sowie des Trägerelementes richten sich nach dem verwendeten Lichtwellenleiter sowie dem Photodetektor.

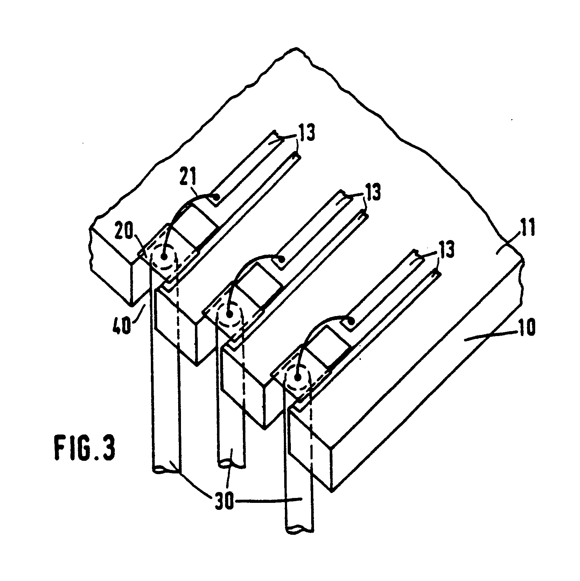

Bei der in FIG. 3 beispielhaft dargestellten Weiterbildung der Erfindung sind bei einem plattenförmigen Trägerelement eine oder mehrere Vertiefung(en) 40 derart angebracht, daß in diesen gleichzeitig mehrere Lichtwellenleiter 30 befestigt werden können. Auf der Seitenfläche 11 des Trägerelementes 10 sind, entsprechend den FIG. 2a, 2b, mehrere Photodetektoren 20 angebracht. Auf der Seitenfläche 11 sind außerdem elektrische Zuleitungen 13, z. B. Leiterbahnen, vorhanden, die elektrische Anschlüsse für die Photodetektoren bewirken. Eine derartige Anordnung ermöglicht z. B. auf dem Trägerelement 10 ein elektrisches Netzwerk zu integrieren (Hybrid-Technik), so daß eine elektrische Auswertung der in den Lichtwellenleitern ankommenden optischen Signale vornehmbar ist.

**Patentansprüche**

1. Opto-elektrische Koppelanordnung, bestehend aus
- einem Trägerelement, in dem mindestens eine grabenförmige Vertiefung vorhanden ist,
- mindestens einem Lichtwellenleiter, welcher in jeweils einer der grabenförmigen Vertiefungen befestigt ist, sowie
- mindestens eine Halbleiter-Photodetektor, der das aus der Endfläche des Lichtwellenleiters austretende Licht in ein elektrisches Signal umwandelt, dadurch gekennzeichnet,
- daß in der Vertiefung (40) mindestens ein Lichtwellenleiter (30) derart befestigt ist, daß dessen eine Endfläche (31) im wesentlichen in einer Ebene liegt mit einer Seitenfläche (11) des Trägerelementes (10), und
- daß auf dieser Seitenfläche (11) mindestens ein Photodetektor (20) derart befestigt ist, daß das aus der Endfläche (31) austretende Licht im wesentlichen vollständig auf den lichtempfindlichen Bereich des Photodetektors (20) fällt.

2. Koppelanordnung nach Anspruch 1, dadurch gekennzeichnet, daß mindestens ein Lichtwellenleiter (30) als Glasfaser-Lichtwellenleiter ausgebildet ist.

3. Koppelanordnung nach einem der Ansprüche 1 oder 2, dadurch gekennzeichnet, daß die Seitenfläche (11) zumindest im Bereich der Vertiefung als ein elektrischer Kontakt (12) für den Photodetektor (20) ausgebildet ist.

4. Koppelanordnung nach einem der Ansprüche 1 bis 3, dadurch gekennzeichnet, daß auf mindestens einer Seitenfläche (11) des Trägerelementes (10) mindestens eine elektrische Leiterbahn (13) aufgebracht ist, die elektrisch mit dem Photodetektor (20) verbunden ist.

5. Koppelanordnung nach einem der Ansprüche 1 bis 4, dadurch gekennzeichnet, daß die Vertiefung (40) eine Breite (41) hat, die unwesentlich größer ist als der Durchmesser des Lichtwellenleiters (30).

6. Koppelanordnung nach einem der Ansprüche 1 bis 5, dadurch gekennzeichnet, daß mindestens ein Photodetektor als Teil eines integrierten Halbleiterbauelementes ausgebildet ist.

**Claims**

1. Opti-electrical coupling arrangement consisting of
-a carrier element, in which at least one ditch-like depression is present,
- at least one optical conductor which is fastened in a respective one of the ditch-shaped depressions as well as
- at least one semiconductor photo-sensitive detector which converts the light issuing from the end surface of the optical conductor into an electrical signal, characterised thereby,
- that at least one optical conductor (30) is fastened in the depression (40) in such a manner that its one end surface (31) lies substantially in one plane with a side surface (11) of the carrier element (10) and
- at least one photo-sensitive detector (20) is fastened on this side surface (20) in such a manner that the light issuing from the end surface (31) falls substantially completely on the light-sensitive region of the photo-sensitive detector (20).

2. Coupling arrangement according to claim 1, characterised thereby, that at least one optical conductor (30) is constructed as glass fibre optical conductor.

3. Coupling arrangement according to one of the claims 1 or 2, characterised thereby, that the side surface (11) is constructed at least in the region of the depression as an electrical contact (12) for the photo-sensitive detector (20).

4. Coupling arrangement according to one of the claims 1 to 3, characterised thereby, that at least one electrical conductor track (13), which is electrically connected with the photosensitive detector (20), is mounted on at least one side surface (11) of the carrier element (10).

5. Coupling arrangement according to one of the claims 1 to 4, characterised thereby, that the depression (40) has a width which is insubstantially greater than the diameter of the optical conductor (30).

6. Coupling arrangement according to one of the claims 1 to 5, characterised thereby, that at least one photo-sensitive detector is constructed as part of an integrated semiconductor component.

**Revendications**

1. Coupleur opto-électronique constitué par:
- un support comportant au moins un évidement,

- au moins un guide optique fixé dans un des évidements, et

- au moins un photodétecteur à semiconducteurs, qui convertit la lumière sortant de la face d'extrémité du guide optique en un signal électrique,

et caractérisé en ce que:

-un guide optique (30) au moins est fixé dans l'évidement (40), de façon que sa face d'extrémité (31) se situe sensiblement dans le même plan qu'une face latérale (11) du support (10); et

-un photodétecteur (20) au moins est fixé sur cette face latérale (11), de façon que pratiquement toute la lumière sortant de la phase d'extrémité (31) tombe sur la zone photosensible du photodétecteur (20).

2. Coupleur selon revendication 1, caractérisé en ce qu'un guide optique (30) au moins est réalisé sous forme d'un guide en fibres de verre.

3. Coupleur selon une des revendications 1 ou 2, caractérisé en ce que la face latérale (11) est réalisée, au moins dans la zone de l'évidement, sous forme d'un contact électrique (12) pour le photodétecteur (20).

4. Coupleur selon une quelconque des revendications 1 à 3, caractérisé en ce qu'un ruban conducteur (13) au moins, relié électriquement au photodétecteur (20), est disposé sur une face latérale (11) au moins du support (10).

5. Coupleur selon une quelconque des revendications 1 à 4, caractérisé en ce que l'évidement (40) présente une largeur (41) légèrement supérieure au diamètre du guide optique (30).

6. Coupleur selon une quelconque des revendications 1 à 5, caractérisé en ce qu'un photodétecteur au moins est réalisé sous forme d'une partie d'un composant intégré à semiconducteurs.

FIG.1

20

10

101

30

FIG.2a

30

31

21

20

40

11

10

50

FIG.2b

41

21

20

30

40

12

10

50

**FIG.3**